# EUROPÄISCHE PATENTSCHRIFT

(11) **EP 2 460 174 B1**
(45) Veröffentlichungstag und Bekanntmachung des Hinweises auf die Patenterteilung: **06.09.2017**
(21) Anmeldenummer: 10734925.0
(22) Anmeldetag: 21.07.2010
(51) Int. Cl.: H01J 37/32, B05D 7/24, B29C 59/14, C23C 14/04

(54) **PLASMASTEMPEL UND VERFAHREN ZUR PLASMABEHANDLUNG EINER OBERFLÄCHE**
PLASMA STAMP AND METHOD FOR PLASMA TREATING A SURFACE
MOULE MÂLE A PLASMA ET PROCÉDÉ DE TRAITEMENT PAR PLASMA D'UNE SURFACE

(30) Priorität: 31.07.2009 DE 102009035411
(43) Veröffentlichungstag der Anmeldung: 06.06.2012
(73) Patentinhaber: Fraunhofer-Gesellschaft zur Förderung der angewandten Forschung e.V., 80686 München (DE)
(72) Erfinder: THOMAS, Michael, 31275 Lehrte (DE); KLAGES, Claus-Peter, 38102 Braunschweig (DE); DOHSE, Antje, 38179 Lagesbüttel (DE)
(74) Vertreter: Pfenning, Meinig & Partner mbB
(86) Internationale Anmeldenummer: PCT/EP2010/004468
(87) Internationale Veröffentlichungsnummer: WO 2011/012255

(56) Entgegenhaltungen:
- WO-A1-01/69644
- WO-A2-2007/011388
- DE-B3- 10 322 696
- US-A1- 2005 148 270
- US-B1- 6 827 870
- LUCAS N ET AL: "Microplasma stamps for selective surface modification: design and characterization", JOURNAL OF PHYSICS D: APPLIED PHYSICS, Bd. 41, Nr. 21, 7. November 2008 (2008-11-07), Seiten 1-7, XP002607682, IOP PUBLISHING LTD. UK ISSN: 0022-3727

## Beschreibung

Die Erfindung betrifft einen Plasmastempel, mittels welchem eine Oberfläche eines Objektes plasmabehandelt werden kann, ohne dass hinter dem Substrat eine Elektrode angeordnet werden muss. Die Erfindung betrifft außerdem ein Verfahren zur Plasmabehandlung einer Oberfläche, das mit dem erfindungsgemäßen Plasmastempel durchgeführt werden kann.

Der Begriff Plasmastempel beinhaltet dabei sowohl ebene Stempel als auch dreidimensional geformte Stempel, sowie als Zylinder ausgebildete Anordnungen.

Bei Verfahren zur mikrostrukturierten Funktionalisierung, Behandlung oder Beschichtung von Oberflächen mittels eines Plasmas nach dem Stand der Technik wird ein zu beschichtendes Substrat zwischen zwei Elektroden angeordnet, welche direkt oder über ein Dielektrikum dicht auf der Vorder- und Rückseite des Substrates aufliegen. Auf einer Seite liegen Mikrostrukturen vor, in welchen sich ein Plasma ausbilden kann. Eine solche Vorrichtung ist beispielsweise in der EP 1 264 330 B1 beschrieben. Weitere Ausführungen von Plasmastempeln sind aus US 6 827 870 B1, WO 01/69644 A1 und N. Lucas, J.Phys.D: Appl. Phys 41 (2008) 215202 bekannt. Im Falle dielektrischer Substrate kann eine Elektrode mit Strukturen versehen sein, in welchen sich das Plasma ausbildet. Eine andere Elektrode ist auf der entgegengesetzten Seite des Substrates angeordnet.
Für die Beschichtung von elektrisch leitfähigen Substraten kann auch zwischen einer ersten Elektrode und dem zu beschichtenden Substrat eine dielektrische Schicht angeordnet sein, in welcher Strukturen eingebracht sind, so dass von der ersten Elektrode und dielektrischem Material umgebene Kavitäten entstehen, in welchen sich das Plasma ausbildet. Auch kontaktlose Beschichtungsverfahren sind möglich. Hierzu kann eine Elektrode, auf welcher eine Struktur eingebracht ist, in einem Abstand zum Substrat über dem Substrat angeordnet werden. Zwischen dieser ersten Elektrode und einer auf der entgegengesetzten Seite des Substrates angeordneten Elektrode wird dann eine Spannung angelegt, wodurch sich ein Plasma nur auf den erhabenen Strukturen der ersten Elektrode entzündet.
Mit den Anordnungen nach dem Stand der Technik ist es sehr schwer, dickere dielektrische Substrate zu behandeln, da hierzu sehr hohe elektrische Spannungen benötigt werden. Dies führt zu unerwünschten Gleitentladungen und damit zu Behandlungen in unerwünschten Bereichen. Auch dreidimensionale Bauteile können nur mit hohem Aufwand selektiv behandelt werden. Zudem besteht das Problem, dass poröse Substrate wie z.B. Textilien, Vliese oder Membrane nicht mikrostrukturiert funktionalisiert werden können und darüberhinaus auch eine Tiefenwirkung der Behandlung nicht eingestellt werden kann. Es wird immer vollflächig das komplette Material behandelt. Darüber hinaus ist eine optische Beobachtung des Plasmas in der Entladung nur bei Einsatz transparenter Elektroden möglich.
Aufgabe der vorliegenden Erfindung ist es daher, die genannten Probleme des Standes der Technik zu überwinden und insbesondere die Beschichtung beliebiger Substrate zu ermöglichen.
Diese Aufgabe wird gelöst durch den Plasmastempel nach Anspruch 1 und das Verfahren zur Plasmabehandlung einer Oberfläche nach Anspruch 8. Die jeweiligen abhängigen Ansprüche geben vorteilhafte Weiterbildungen des erfindungsgemäßen Plasmastempels und des erfindungsgemäßen Verfahrens an.
Der Begriff Plasmastempel beinhaltet dabei sowohl ebene Stempel als auch dreidimensional geformte Stempel, sowie als Zylinder ausgebildete Anordnungen.
Es wurde erfindungsgemäß gefunden, dass es möglich ist, ein Substrat einer Plasmabehandlung zu unterziehen, wenn das Plasma in geeigneter Weise zwischen zwei Elektroden ausgebildet wird, die auf der gleichen Seite eines Substrats angeordnet und durch ein Dielektrikum voneinander getrennt sind.
Erfindungsgemäß wird daher ein Plasmastempel angegeben, der zumindest eine Kavität aufweist, in welcher ein Plasma zündbar ist. Diese Kavität weist eine Öffnung auf, vor welcher ein zu behandelndes Substrat anordenbar ist. Auf einer der Öffnung gegenüber liegenden Seite der Kavität wird die Kavität durch einen Boden begrenzt, der elektrisch nicht leitend ist. Zwischen der Öffnung und dem Boden ist nun eine Wand der Kavität angeordnet, die zumindest bereichsweise elektrisch leitfähig ist. Diese Wand fungiert als eine erste Elektrode zur Erzeugung eines Plasmas in der Kavität. Erfindungsgemäß ist eine zweite Elektrode zur Erzeugung des Plasmas auf einer der Kavität abgewandten Seite des Bodens der Kavität angeordnet. Der Boden befindet sich also zwischen der Kavität und der zweiten Elektrode. Es kann nun zwischen der ersten und der zweiten Elektrode eine Spannung angelegt werden, wodurch in der Kavität ein Plasma gezündet werden kann. Wird dann vor der Öffnung der Kavität ein Substrat angeordnet, so ist dieses mittels des in der Kavität erzeugten Plasmas behandelbar.

Bevorzugterweise ist der Plasmastempel in Schichten wie folgt aufgebaut. Zunächst weist der Plasmastempel vorzugsweise eine erste flächige, leitfähige Schicht auf, die als erste Elektrode fungiert. Über dieser ersten Schicht, also der ersten Elektrode, ist eine erste dielektrische Schicht angeordnet, die als Boden einer, mehrerer oder aller Kavitäten fungieren kann. Über dieser Schicht ist nun eine zweite flächige leitfähige Schicht als zweite Elektrode angeordnet. In der ersten leitfähigen Schicht, also in der ersten Elektrode, ist zumindest ein Durchgang ausgebildet, welcher sich von einer der ersten dielektrischen Schicht zugewandten Oberseite der ersten Elektrode bis zu einer dieser gegenüberliegenden Unterseite der ersten Elektrode erstreckt. Dieser zumindest eine Durchgang bildet also die zumindest eine Kavität des Plasmastempels. Der Boden dieser Kavität wird durch die beschriebene erste dielektrische. Schicht gebildet und die Öffnung der Kavität durch die Öffnung des Durchgangs in der Unterseite der ersten Elektrode.

Die Wand der Elektrode wird also durch die erste leitfähige Schicht gebildet, durch welche hindurch der Durchgang sich erstreckt. Beim Anlegen einer ausreichend hohen Spannung können sich hier Oberflächenentladungen ausbilden, eine spezielle Form der Barriereentladung.

Über und auf bezeichnet hierbei die Richtung vom Substrat weg, während unter die Richtung zum Substrat hin bezeichnet.

In der beschriebenen bevorzugten Ausführungsform wird der Stempel vorzugsweise mit der Unterseite der ersten Elektrode auf dem zu beschichtenden Substrat angeordnet.

Während die erste Elektrode durch die zumindest eine Kavität oder mehrere Kavitäten strukturiert ist, ist die zweite Elektrode vorzugsweise eben ausgebildet. Die Hochspannung kann dann an der vollflächigen zweiten Elektrode anliegen und die Masse an der strukturierten ersten Elektrode. Vorzugsweise weist der erfindungsgemäße Plasmastempel zumindest eine weitere dielektrische Schicht auf, welche zwischen der ersten Elektrode und dem Boden der Kavität oder der ersten dielektrischen Schicht angeordnet ist, wobei zumindest einer der Durchgänge, bevorzugt alle Durchgänge, sich von einer der ersten dielektrischen Schicht zugewandten Oberseite der zweiten dielektrischen Schicht bis zur Unterseite der ersten Elektrode erstreckt. Die Kavitäten werden hierbei also durch die Elektrode sowie eine Wand in der zweiten dielektrischen Schicht gebildet.

Bevorzugterweise ist die zweite dielektrische Schicht unmittelbar auf der Oberseite der ersten Elektrode angeordnet.

Der erfindungsgemäße Plasmastempel kann weiter zumindest eine Gasleitschicht aufweisen, die besonders bevorzugt im oben beschriebenen schichtförmigen Aufbau des Plasmastempels zum Einsatz kommt. Eine solche Gasleitschicht ist dann zwischen der ersten Elektrode und der ersten dielektrischen Schicht bzw. dem Boden angeordnet und weist zumindest ein poröses Material auf oder besteht daraus, durch welches Gas mittels Diffusion oder Konvektion leitbar bzw. strömbar ist. Diese Gasleitschicht steht vorzugsweise mit zumindest einem der zumindest einen Durchgänge der ersten Elektrode, vorzugsweise mit allen Durchgängen der Elektrode, in gasdurchlässiger Verbindung, so dass über die Gasleitschicht Gas in die Kavität bzw. den Durchgang leitbar ist. Vorzugsweise ist die Gasleitschicht unmittelbar auf der Oberseite der ersten Elektrode oder der Oberseite der zweiten dielektrischen Schicht, sofern diese gegeben ist, angeordnet. Die Gasleitschicht ist vorzugsweise unmittelbar unter der ersten dielektrischen Schicht bzw. dem Boden angeordnet. In diesem Falle begrenzt also die Gasleitschicht die Kavität in Richtung der zweiten Elektrode. Der Boden befindet sich dann auf jener der Kavität abgewandten Seite der Gasleitschicht.

Es ist auch möglich, dass sich zumindest einer der Durchgänge, vorzugsweise alle Durchgänge, von einer der ersten dielektrischen Schicht zugewandten Oberseite der Gasleitschicht bis zur Unterseite der ersten Elektrode erstreckt. Der Durchgang erstreckt sich in diesem Fall also durch die erste Elektrode und die Gasleitschicht.

Für die Plasmabehandlung wird der oder den Kavitäten Gas vorzugsweise mit einem Druck ≥ 0,1 bar, besonders bevorzugt ≥ 0,5 bar und/oder ≤ 10 bar, vorzugsweise ≤ 5 bar, besonders bevorzugt ≤ 1,5 bar zugeführt oder das Gas in den Kavitäten mit einem solchen Druck beaufschlagt.

Die Kavitäten bzw. Durchgänge können verschiedene Geometrien haben. Die Geometrie kann einer auf der zu behandelnden Oberfläche zu erzeugenden Struktur angepasst sein. Die Struktur des zu behandelnden Bereiches wird durch die Form der Öffnung der Kavität bzw. des Durchgangs bestimmt. Die Kavitäten können z.B. zylinderförmig sein. In diesem Fall wird die erste Elektrode durch zumindest einen Bereich der Zylinderwand gebildet. Der Zylinder endet dann an der Öffnung der Kavität sowie dem Boden oder einer zwischen Kavität und Boden angeordneten Schicht. Entsprechend kann die Kavität auch quaderförmig ausgebildet sein, wobei die erste Elektrode durch zumindest einen Teil der Wände des Quaders gebildet wird, welche die Öffnung der Kavität umgeben.

Ein Durchmesser der Kavität in Richtung parallel zur Öffnung und/oder eine Kantenlänge der Kavität parallel zur Öffnung oder senkrecht zur Öffnung ist vorzugsweise ≥ 1 µm, besonders bevorzugt ≥ 10 µm, besonders bevorzugt ≥ 50 µm, besonders bevorzugt ≥ 100 µm, besonders bevorzugt ≥ 1 mm und/oder ≤ 10 mm, vorzugsweise ≤5 mm, besonders bevorzugt ≤ 2 mm.

Besonders bevorzugt ist der Plasmastempel eben ausgebildet. Die oben genannten Schichten erstrecken sich daher vorzugsweise in einer Ebene. Im Falle strukturierter Schichten wie der ersten Elektrode bedeutet hierbei "erstrecken", dass die Schicht eben ist, wenn die Strukturierungen nicht berücksichtigt werden.

Erfindungsgemäß wird außerdem ein Verfahren zur Plasmabehandlung einer Oberfläche eines Substrats angegeben. Dabei wird auf der Oberfläche zumindest eine Kavität angeordnet. Die Kavität wird mit einer Öffnung der Kavität so auf der Oberfläche angeordnet, dass die Oberfläche die Kavität bedeckt, abdeckt oder verschließt.

Die Kavität weist eine leitfähige Wand als erste Elektrode auf sowie eine zweite Elektrode, die hinter einem dielektrischen Boden auf einer der Öffnung gegenüberliegenden Seite der Kavität angeordnet ist.

Zwischen der ersten und der zweiten Elektrode wird dann eine Hochspannung so angelegt, dass sich in der Kavität ein Plasma bildet.

Bevorzugterweise wird das Verfahren mit einem Plasmastempel, wie er oben beschrieben wurde, durchgeführt.

Erfindungsgemäß kann in die Kavitäten als Prozessgase u.a. Luft, Stickstoff, Helium und/oder Argon eingebracht werden. Eine Funktionalisierung einer Oberfläche ist beispielsweise mit Stickstoff, Formiergas, Ammoniak zur Bildung von Aminogruppen und anderen möglich. Mittels des erfindungsgemäßen Plasmastempels und des erfindungsgemäßen Verfahrens sind außerdem auch funktionelle Schichten (z.B. hydrophile oder hydrophobe Schichten, Amine, Epoxide, Carbonsäure, Aldehyde und andere) abscheidbar. Die Schichten können über Precursoren, wie Alkoxysilane, Fluorgase, Kohlenwasserstoffe, Silan oder Organosilane, abgeschieden werden.

Mittels des erfindungsgemäßen Plasmastempels und des erfindungsgemäßen Verfahrens sind dicke dielektrische Substrate beschichtbar. Außerdem sind poröse dielektrische Substrate beschichtbar. Es kann darüberhinaus die Tiefe der Behandlung bei porösen dielektrischen Substraten eingestellt werden.

Besonders bevorzugt lässt sich eine Tiefenwirkung z.B. über die Gasgeschwindigkeit (den Gasfluss) und die Gaszufuhr einstellen, d.h. dadurch, ob man von unten durch das poröse Material (Textil, Membran, Schaum, Vlies) strömt oder von oben durch ein poröses Material der Elektrode. Durch Erhöhung des Gasflusses kann man je nach Richtung (unten bzw. oben) die aktiven Spezies aus dem porösen Medium zurückdrängen bzw. tiefer in das Material eindringen lassen.

Unter Plasmabehandlung wird vorliegend Beschichtung, Abscheidung, Aktivierung, Funktionalisierung und ähnliche Prozesse verstanden.

Im Folgenden soll die Erfindung anhand einiger Figuren beispielhaft erläutert werden. Gleiche Bezugszeichen entsprechen gleichen oder entsprechenden Elementen.

Es zeigt
- Figur 1: einen erfindungsgemäßen Plasmastempel,
- Figur 2: einen erfindungsgemäßen Plasmastempel mit einer zweiten dielektrischen Schicht,
- Figur 3: einen erfindungsgemäßen Plasmastempel mit einer zusätzlichen Gasleitschicht,
- Figur 4: einen erfindungsgemäßen Plasmastempel mit einer zusätzlichen Gasleitschicht, in welche sich die Kavitäten erstrecken,
- Figur 5: einen erfindungsgemäßen Plasmastempel mit einer zweiten dielektrischen Schicht sowie einer Gasleitschicht,
- Figur 6: einen dreidimensional verformten Plasmastempel und
- Figur 7: einen Plasmastempel mit zylinderförmiger Oberfläche.

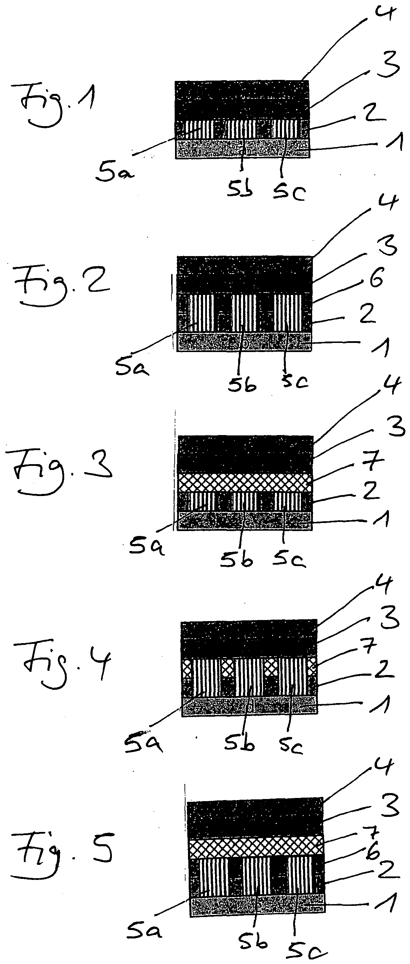

Figur 1 zeigt einen erfindungsgemäßen Plasmastempel, der auf einem Substrat 1 angeordnet ist. Der Plasmastempel weist drei Kavitäten 5a, 5b, 5c auf, vor welchen das Substrat 1 angeordnet ist. Jede der Kavitäten 5a, 5b, 5c weist einen dielektrischen Boden 3 auf, welcher einer Öffnung der Kavität 5a, 5b, 5c gegenüber angeordnet ist. Die Kavitäten 5a, 5b, 5c weisen jeweils elektrisch leitende Wände als erste Elektrode auf, die im gezeigten Beispiel durch die Schicht 2 gebildet werden. Auf jener der Kavität 5a, 5b, 5c abgewandten Seite des Bodens 3 ist eine zweite Elektrode 4 angeordnet. Im in Figur 1 gezeigten Beispiel ist die erste Elektrode als erste flächige leitfähige Schicht 2 ausgebildet. Der Boden 3 ist als erste dielektrische Schicht 3 ausgebildet und über der ersten Elektrode 2 angeordnet.

Die Kavitäten 5a, 5b, 5c erstrecken sich von einer der ersten dielektrischen Schicht 3 zugewandten Oberseite der ersten Elektrode 2 bis zu einer der ersten dielektrischen Schicht 3 abgewandten Unterseite der ersten Elektrode 2, an welcher hier das Substrat 1 angeordnet ist.

Figur 2 zeigt einen erfindungsgemäßen Plasmastempel mit einer zusätzlichen dielektrischen Schicht 6, welcher auf einem Substrat 1 angeordnet ist.

Hier ist zwischen der dielektrischen Schicht 3 und der Elektrode 2 die weitere dielektrische Schicht 6 angeordnet. Die Kavitäten 5a, 5b, 5c erstrecken sich in diesem Falle von einer der ersten dielektrischen Schicht 3 zugewandten Oberseite der zweiten dielektrischen Schicht 6 bis zur Unterseite der leitfähigen Schicht 2, also durch die Schichten 2 und 6 hindurch.

Figur 3 zeigt einen erfindungsgemäßen Plasmastempel mit einer Gasleitschicht 7, der auf einem Substrat 1 angeordnet ist. Die Gasleitschicht 7 ist hierbei zwischen der ersten dielektrischen Schicht 3 und der Elektrodenschicht 2 angeordnet. Die Gasleitschicht 7 steht mit den Kavitäten 5a, 5b, 5c in gasdurchlässiger Verbindung, so dass über die Gasleitschicht 7 Prozessgas in die Kavitäten 5a, 5b, 5c einleitbar ist. Die Kavitäten 5a, 5b, 5c erstrecken sich in diesem Falle zwischen dem Substrat 1 und der Gasleitschicht 7. Die erste dielektrische Schicht 3 ist auf jener der zweiten Elektrode abgewandten Seite der Gasleitschicht 7 angeordnet.

Im gezeigten Beispiel ist die Gasleitschicht 7 unmittelbar auf der Elektrode 2 angeordnet und die erste dielektrische Schicht unmittelbar auf der Gasleitschicht 7 angeordnet.

Figur 4 zeigt einen erfindungsgemäßen Plasmastempel mit einer Gasleitschicht 7, in welche sich die Kavitäten 5a, 5b, 5c erstrecken, welcher auf einem Substrat 1 untergebracht ist. Im gezeigten Beispiel ist die Gasleitschicht 7 wie im in Figur 3 gezeigten Beispiel angeordnet. Anders als in Figur 3 erstrecken sich die Kavitäten jedoch durch die Gasleitschicht 7 hindurch, d.h. von der Unterseite der ersten Elektrode 2 bis zur Unterseite der dielektrischen Schicht 3, also einer Oberseite der Gasleitschicht 7.

Figur 5 zeigt schließlich einen erfindungsgemäßen Plasmastempel, der auf einem Substrat 1 angeordnet ist. Der in Figur 5 gezeigte Plasmastempel weist eine zweite dielektrische Schicht 6 auf, wobei sich die Kavitäten 5a, 5b, 5c sowohl durch die Elektrode 2 wie auch die zweite dielektrische Schicht 6 erstrecken. Der gezeigte Plasmastempel weist außerdem eine Gasleitschicht 7 auf, welche zwischen der zweiten dielektrischen Schicht 6 und der ersten dielektrischen Schicht 3 angeordnet ist. Über die Gasleitschicht 7 ist den Kavitäten 5a, 5b, 5c Prozessgas zuführbar. Die zweite Elektrode 4 ist wiederum zuoberst auf der ersten dielektrischen Schicht 3 angeordnet. Wird im gezeigten Beispiel eine Spannung zwischen der ersten Elektrode 2 und der zweiten Elektrode 4 angelegt, so entsteht in den Kavitäten 5a, 5b, 5c ein Plasma.

Die in den Beispielen gezeigten Kavitäten können Abmessungen zwischen beispielsweise 1 µm und 10 mm haben, wobei hier ein Durchmesser der Kavität 5a, 5b, 5c und/oder eine Breite der Kavität 5a, 5b, 5c gemeint ist. Eine Tiefe der Kavität 5a, 5b, 5c, d.h. eine Dicke der Elektrodenschicht 2 und/oder der zweiten dielektrischen Schicht und/oder der Gasleitschicht 7, beträgt vorzugsweise zwischen 5 µm und 2 mm. Eine Länge der Kavitäten kann auch mehrere Meter betragen.

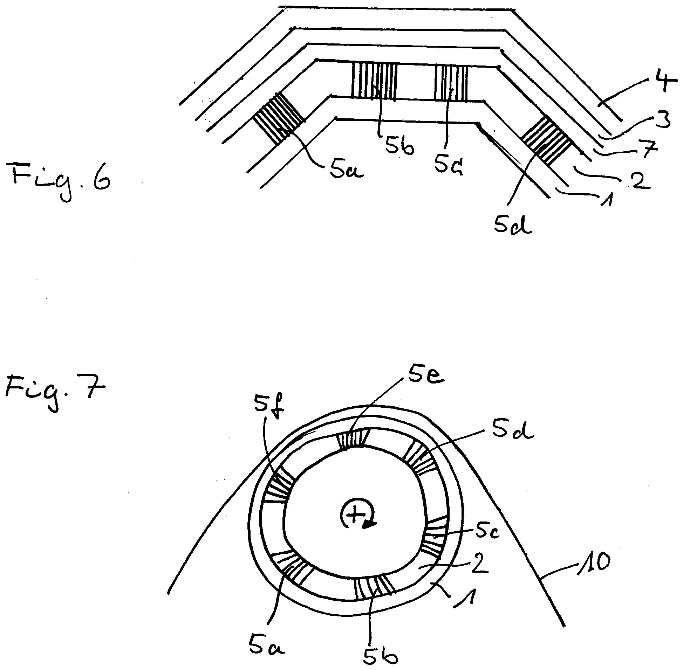

Die in den Figuren 1 bis 5 gezeigten Anordnungen können auch dreidimensional, z.B. für die Behandlung von Kunststoff-Bauteilen, die mittels Spritzguss hergestellt werden, ausgeführt werden. Ebenso ist eine radiale Anordnung der in den Figuren 1 bis 5 dargestellten Strukturen auf einem Zylinder möglich. Derartige Varianten sind in den Figuren 6 und 7 dargestellt.

Das Substrat und/oder die zweite Elektrode 4 und/oder die dielektrische Schicht 3 kann in den in den Figuren gezeigten Beispielen durchsichtig sein, so dass die Plasmaentladung in den Kavitäten 5a, 5b, 5c von außen beobachtbar ist. Mit den gezeigten Plasmastempeln ist beispielsweise eine Beschichtung, eine Abscheidung von Stoffen, wie funktionellen Schichten und Precursoren, eine Funktionalisierung mit Gasen sowie die Behandlung dicker dielektrischer Substrate 1, poröser dielektrischer Substrate 1, vorzugsweise mit einstellbarer Tiefenwirkung möglich.

Im Folgenden soll das erfindungsgemäße Verfahren anhand dreier Beispiele erläutert werden.

Zunächst soll eine Vorbehandlung einer Folie mittels des erfindungsgemäßen Verfahrens beschrieben werden.

Eine 75 µm dicke Polypropylenfolie wird mit einer Anordnung nach Fig. 2 20 s lang mit einer Gasmischung von 14 slm Helium und 6 slm Formiergas (10 % H₂) und einer Leistung von 11 W bei einer Frequenz von 30 kHz behandelt. Bei Benetzung mit Wasser erkennt man deutlich eine homogen strukturierte Behandlung der Folienoberfläche. Die Oberflächenspannung steigt in den behandelten Bereichen von 22 mN/m auf 64 mN/m.

Als weiteres Verfahrensbeispiel soll die Vorbehandlung eines Polyestergewebes beschrieben werden.

Ein mit einer hydrophoben Beschichtung ausgestattetes Polyestergewebe wird mit einer Anordnung nach Fig. 2 20 s lang mit einer Gasmischung von 10 slm N₂ durch APTMS Aminopropyltrimethoxysilan und einer Leistung von 17 W bei einer Frequenz von 28 kHz behandelt. Bei Benetzung mit Wasser erkennt man deutlich eine homogen strukturierte Behandlung des Polyestergewebes. Die Rückseite des Gewebes ist weiter superhydrophob und wurde damit also nicht durch die Behandlung beeinflusst.

Es soll weiterhin noch die Beschichtung eines Glassubstrates als Beispiel beschrieben werden.

Ein 4 mm dickes Glassubstrat wird hierzu mit einer Anordnung nach Fig. 5 120 s lang mit einer Gasmischung von 3 slm He und 0,03 slm Acetylen bei einer Leistung von 10 W und einer Frequenz von 28 kHz beschichtet. Es bildet sich eine für die Abscheidung typische gelbbraune Schicht ortsselektiv auf der Glasoberfläche aus.

Figur 6 zeigt einen erfindungsgemäßen Plasmastempel, wie er beispielsweise vom Grundaufbau her bereits in Figur 3 gezeigt wurde. Die entsprechenden Bezugszeichen werden daher nicht nochmals erläutert, soweit sie dieselbe Bedeutung wie in Figur 3 aufweisen. Auch die weiteren Anordnungen der Figuren 1, 2, 4 und 5 können als ein derartiger Plasmastempel wie in Figur 6 implementiert werden.

Abweichend von Figur 3 ist bei dem in Figur 6 gezeigten Plasmastempel das Substrat 1 und/oder die erste Elektrode 2 nicht mit einer ebenen Oberfläche ausgestattet, sondern dreidimensional verformt, nämlich zwischen den Kavitäten 5a und 5b bzw. zwischen den Kavitäten 5c und 5d jeweils abgeknickt. Damit ist es auch möglich, einen dreidimensional verformten Gegenstand zu beschichten.

Figur 7 zeigt eine weitere Variante eines erfindungsgemäßen Plasmastempels, wobei hier der Plasmastempel eine zylinderförmige Oberfläche aufweist, längs deren Umfangsrichtung die Kavitäten 5a bis 5f angeordnet sind. Außen liegend an dem zylinderförmigen Plasmastempel befindet sich das Plasmastempelsubstrat 1. Wird nun der Plasmastempel gemäß Figur 7 um seine Längsachse (wie mit dem Kreuz mittig gekennzeichnet in Figur 7) gedreht, so kann über seine Oberfläche ein zu beschichtendes Band 10 geführt werden. Auch in Figur 7 sind die einzelnen Schichten und Kavitäten wie in den Figuren 1 bis 5 bereits dargestellt aufgebaut. Dabei wurden in Figur 7 jedoch nur die Substratschicht 1 sowie die Elektrodenschicht 2 und die Kavitäten 5a bis 5f dargestellt. Auf die Darstellung der weiteren Schichten 3, 4, 6 oder 7, wie in den Figuren 1 bis 5 dargestellt, wurde verzichtet. Sie können jedoch gegebenenfalls so, wie zu den Figuren 1 bis 5 beschrieben, auch bei diesem Plasmastempel in Figur 7 vorhanden sein.

## Patentansprüche

1. Plasmastempel mit zumindest einer Kavität (5a, 5b, 5c), die zumindest eine Öffnung, vor welcher ein zu behandelndes Substrat (1) anordbar ist,
einen der Öffnung gegenüber angeordneten dielektrischen Boden (3) und eine zwischen der Öffnung und dem Boden (3) angeordnete, zumindest bereichsweise elektrisch leitfähige Wand als erste Elektrode (2) aufweist sowie
mit einer zweiten Elektrode, welche auf einer der Kavität (5a, 5b, 5c) abgewandten Seite des Bodens (3) angeordnet ist.

2. Plasmastempel nach dem vorhergehenden Anspruch, mit einer ersten flächigen, leitfähigen Schicht als erster Elektrode (2), einer über der ersten Elektrode angeordneten ersten dielektrischen Schicht (3) als Boden sowie einer über der ersten dielektrischen Schicht (3) angeordneten zweiten flächigen leitfähigen Schicht (4) als zweiter Elektrode,
wobei die erste Elektrode zumindest einen Durchgang als Kavität (5a, 5b, 5c) aufweist, welcher sich von einer der ersten dielektrischen Schicht (3) zugewandten Oberseite der ersten Elektrode (2) zu einer dieser gegenüberliegenden Unterseite der ersten Elektrode (2) erstreckt, so dass in der Unterseite der ersten Elektrode (2) die Öffnung gebildet wird.

3. Plasmastempel nach dem vorhergehenden Anspruch, **gekennzeichnet durch** zumindest eine zweite dielektrische Schicht (6), die zwischen der ersten Elektrode (2) und der ersten dielektrischen Schicht (3) angeordnet ist, wobei
der zumindest eine Durchgang sich von einer der ersten dielektrischen Schicht (3) zugewandten Oberseite der zweiten dielektrischen Schicht (6) bis zur Unterseite der ersten Elektrode (2) erstreckt,
wobei vorzugsweise die zweite dielektrische Schicht (6) unmittelbar auf der Oberseite der ersten Elektrode (2) angeordnet ist.

4. Plasmastempel nach einem der Ansprüche 2 bis 3, **gekennzeichnet durch** zumindest eine zwischen der ersten Elektrode (2) und der ersten dielektrischen Schicht (3) angeordnete Gasleitschicht (7) zum Leiten von Gas, welche zumindest ein poröses Material aufweist oder daraus besteht und welche mit dem zumindest einen Durchgang in gasdurchlässiger Verbindung steht, wobei vorzugsweise die Gasleitschicht (7) unmittelbar auf der Oberseite der ersten Elektrode (2) oder der Oberseite der zweiten dielektrischen Schicht (6) angeordnet ist und/oder die Gasleitschicht (7) unmittelbar unter der ersten dielektrischen Schicht (3) angeordnet ist.

5. Plasmastempel nach Anspruch 4, **dadurch gekennzeichnet, dass** sich der zumindest eine Durchgang von einer der ersten dielektrischen Schicht (3) zugewandten Oberseite der Gasleitschicht (7) bis zur Unterseite der ersten Elektrode (2) erstreckt.

6. Plasmastempel nach einem der Ansprüche 2 bis 5, **gekennzeichnet durch** eine dritte dielektrische Schicht, die unter der Unterseite der ersten Elektrode (2) angeordnet ist, wobei sich der zumindest eine Durchgang bis zu einer der ersten Elektrode (2) abgewandten Unterseite der dritten dielektrischen Schicht erstreckt.

7. Plasmastempel nach einem der Ansprüche 2 bis 6, **dadurch gekennzeichnet, dass** die erste Elektrode (2) sich in einer Ebene erstreckt, oder dass die erste Elektrode (2) sich in einer dreidimensional verformten Oberfläche erstreckt, wobei vorzugsweise die dreidimensional verformte Oberfläche eine Zylinderfläche ist.

8. Verfahren zur Plasmabehandlung einer Oberfläche, wobei auf der Oberfläche zumindest eine Kavität (5a, 5b, 5c) angeordnet wird, wobei die Kavität mit einer Öffnung der Kavität auf der Oberfläche angeordnet wird,
und wobei eine Spannung zwischen einer leitfähigen Wand der Kavität als einer ersten Elektrode (2) einerseits und einer zweiten Elektrode (4) andererseits angelegt wird, so dass in der Kavität ein Plasma entsteht, wobei die zweite Elektrode (4) auf einer der Kavität abgewandten Seite eines dielektrischen Bodens (3) der Kavität angeordnet ist, welcher der Öffnung der Kavität gegenüber angeordnet ist.

9. Verfahren nach dem vorhergehenden Anspruch, **dadurch gekennzeichnet, dass** eine Mehrzahl der Kavitäten auf der Oberfläche angeordnet wird, wobei die Kavitäten als Durchgänge in einer elektrisch leitfähigen Schicht ausgestaltet sind.

10. Verfahren nach einem der Ansprüche 8 bis 9, **dadurch gekennzeichnet, dass** das Verfahren ein Verfahren zur Abscheidung zumindest einer funktionellen Schicht über zumindest einen Precursor ist, wobei die funktionelle Schicht hydrophil, hydrophob, eine Aminschicht, eine Epoxidschicht, eine Carbonsäureschicht oder eine Aldehydschicht ist und wobei zumindest ein Precursor Alkoxysilan, Fluorgas, Kohlenwasserstoff, Silan oder Organosilan aufweist oder daraus besteht.

11. Verfahren nach einem der Ansprüche 8 bis 10, **dadurch gekennzeichnet, dass** eine Oberfläche
eines dielektrischen Substrats beschichtet wird, wobei eine Dicke des dielektrischen Substrats ≥ 1 mm, vorzugsweise ≥ 2 mm, besonders bevorzugt ≥ 10 mm, ist.

12. Verfahren nach einem der Ansprüche 8 bis 11, wobei ein poröses dielektrisches Substrat behandelt wird und eine Tiefe der Behandlung in das Substrat voreingestellt wird, wobei vorzugsweise die Tiefe über die Gasgeschwindigkeit und/oder den Gasfluss eingestellt wird.

13. Verfahren nach einem der Ansprüche 8 bis 12, **dadurch gekennzeichnet, dass** die Oberfläche eines dielektrischen Substrats behandelt wird, vorzugsweise dass die Oberfläche eines Textils, eines Vlieses oder einer Membran behandelt wird.

14. Verfahren nach einem der Ansprüche 8 bis 13, **dadurch gekennzeichnet, dass** das Gas der Kavität von jener der Kavität abgewandten Seite der zu beschichtenden Oberfläche durch die Oberfläche hindurch zugeleitet wird.

15. Verfahren nach einem der Ansprüche 8 bis 14, **dadurch gekennzeichnet, dass** das Plasma während des Verfahrens optisch beobachtet wird.

## Claims

1. Plasma stamp having at least one cavity (5a, 5b, 5c) which has at least one opening, in front of which a substrate (1) to be treated can be arranged, a dielectric base (3) arranged opposite the opening, and, as a first electrode (2), a wall arranged between the opening and the base (3), said wall being electrically conductive at least in some regions, and also having a second electrode which is arranged on a side of the base (3) facing away from the cavity (5a, 5b, 5c).

2. Plasma stamp according to the preceding claim, having a first flat conductive layer as the first electrode (2), a first dielectric layer (3) as the base arranged over the first electrode, and a second flat conductive layer (4) as the second electrode arranged over the first dielectric layer (3), wherein the first electrode has as the cavity (5a, 5b, 5c) at least one passage which extends from an upper side of the first electrode (2) facing towards the first dielectric layer (3) to an opposite underside of the first electrode (2) so that the opening is formed in the underside of the first electrode (2).

3. Plasma stamp according to the preceding claim, **characterized by** at least one second dielectric layer (6) which is arranged between the first electrode (2) and the first dielectric layer (3), wherein the at least one passage extends from an upper side of the second dielectric layer (6) facing towards the first dielectric layer (3) to the underside of the first electrode (2), wherein preferably the second dielectric layer (6) is arranged directly on the upper side of the first electrode (2).

4. Plasma stamp according to any of claims 2 to 3, **characterized by** at least one gas conducting layer (7) for conducting gas, said gas conducting layer being arranged between the first electrode (2) and the first dielectric layer (3) and comprising or consisting of at least one porous material and being connected to the at least one passage in a gas-permeable manner, wherein preferably the gas conducting layer (7) is arranged directly on the upper side of the first electrode (2) or on the upper side of the second dielectric layer (6) and/or the gas conducting layer (7) is arranged directly below the first dielectric layer (3).

5. Plasma stamp according to claim 4, **characterized in that** the at least one passage extends from an upper side of the gas conducting layer (7) facing towards the first dielectric layer (3) to the underside of the first electrode (2).

6. Plasma stamp according to any of claims 2 to 5, **characterized by** a third dielectric layer which is arranged below the underside of the first electrode (2), wherein the at least one passage extends to an underside of the third dielectric layer facing away from the first electrode (2).

7. Plasma stamp according to any of claims 2 to 6, **characterized in that** the first electrode (2) extends in one plane, or **in that** the first electrode (2) extends in a three-dimensionally shaped surface, wherein preferably the three-dimensionally shaped surface is a cylindrical surface.

8. Method for plasma treating a surface, wherein at least one cavity (5a, 5b, 5c) is arranged on the surface, wherein the cavity is arranged with an opening of the cavity on the surface, and wherein a voltage is applied between a conductive wall of the cavity as a first electrode (2) on the one hand and a second electrode (4) on the other hand, so that a plasma is created in the cavity, wherein the second electrode (4) is arranged on a side of a dielectric base (3) of the cavity facing away from the cavity, said dielectric base being arranged opposite the opening of the cavity.

9. Method according to the preceding claim, **characterized in that** a plurality of cavities are arranged on the surface, wherein the cavities are configured as passages in an electrically conductive layer.

10. Method according to any of claims 8 to 9, **characterized in that** the method is a method for depositing at least one functional layer via at least one precursor, wherein the functional layer is hydrophilic, hydrophobic, an amine layer, an epoxy layer, a carboxylic acid layer or an aldehyde layer, and wherein at least one precursor comprises or consists of alkoxysilane, fluorine gas, hydrocarbon, silane or organosilane.

11. Method according to any of claims 8 to 10, **characterized in that** a surface of a dielectric substrate is coated, wherein a thickness of the dielectric substrate is ≥ 1 mm, preferably ≥ 2 mm, particularly preferably ≥ 10 mm.

12. Method according to any of claims 8 to 11, wherein a porous dielectric substrate is treated and a depth of the treatment in the substrate is preset, wherein preferably the depth is set via the gas velocity and/or the gas flow.

13. Method according to any of claims 8 to 12, **characterized in that** the surface of a dielectric substrate is treated, preferably **in that** the surface of a textile, of a nonwoven or of a membrane is treated.

14. Method according to any of claims 8 to 13, **characterized in that** the gas of the cavity is conducted through the surface from that side of the surface to be coated that faces away from the cavity.

15. Method according to any of claims 8 to 14, **characterized in that** the plasma is observed optically during the method.

## Revendications

1. Poinçon à plasma avec au moins une cavité (5a, 5b, 5c), qui comprend au moins une ouverture, devant laquelle un substrat (1) à traiter peut être disposé, un fond diélectrique (3) disposé en face de l'ouverture et une paroi au moins partiellement électro-conductrice disposée entre l'ouverture et le fond (3) en tant que première électrode (2), et avec une deuxième électrode, qui est disposée sur un côté du fond (3) opposé à la cavité (5a, 5b, 5c).

2. Poinçon à plasma selon la revendication précédente, avec une première couche conductrice plate en tant que première électrode (2), une première couche diélectrique (3) disposée au-dessus de la première électrode, en tant que fond et une deuxième couche conductrice plate (4) disposée au-dessus de la première couche diélectrique (3), en tant que deuxième électrode,
la première électrode comprenant au moins un passage, en tant que cavité (5a, 5b, 5c), qui s'étend d'un côté supérieur de la première électrode (2) orientée vers la première couche diélectrique (3) vers un côté inférieur de la première électrode (2), opposé à celui-ci, de façon à ce que l'ouverture soit formée au niveau du côté inférieur de la première électrode (2).

3. Poinçon à plasma selon la revendication précédente, **caractérisé par** au moins une deuxième couche diélectrique (6) qui est disposée entre la première électrode (2) et la première couche diélectrique (3), l'au moins un passage s'étendant du côté supérieur de la deuxième couche diélectrique (6) orienté vers la première couche diélectrique (3) vers le côté inférieur de la première électrode (2), de préférence la deuxième couche diélectrique (6) étant disposée directement sur le côté supérieur de la première électrode (2).

4. Poinçon à plasma selon l'une des revendications 2 à 3, **caractérisé par** au moins une couche de conduction de gaz (7), disposée entre la première électrode (2) et la première couche diélectrique (3), pour la conduction de gaz, qui comprend au moins un matériau poreux ou est constituée de celui-ci et qui est relié avec l'au moins un passage de manière perméable aux gaz, de préférence la couche de conduction de gaz (7) étant disposée directement sur le côté supérieur de la première électrode (2) ou sur le côté supérieur de la deuxième couche diélectrique (6) et/ou la couche de conduction de gaz (7) est disposée directement sous la première couche diélectrique (3).

5. Poinçon à plasma selon la revendication 4, **caractérisé en ce que** l'au moins un passage s'étend d'un côté supérieur de la couche de conduction de gaz (7) orienté vers la première couche diélectrique (3) au côté inférieur de la première électrode (2).

6. Poinçon à plasma selon l'une des revendications 2 à 5, **caractérisé par** une troisième couche diélectrique qui est disposée sous le côté inférieur de la première électrode (2), l'au moins un passage s'étendant jusqu'à un côté inférieur de la troisième couche diélectrique opposé à la première électrode (2).

7. Poinçon à plasma selon l'une des revendications 2 à 6, **caractérisé en ce que** la première électrode (2) s'étend dans un plan ou **en ce que** la première électrode (2) s'étend dans une surface formée de manière tridimensionnelle, de préférence la surface formée de manière tridimensionnelle étant une surface cylindrique.

8. Procédé pour le traitement au plasma d'une surface, au moins une cavité (5a, 5b, 5c) étant disposée sur la surface, la cavité étant disposée avec une ouverture de la cavité sur la surface, et une tension est appliquée entre une paroi conductrice de la cavité, en tant que première électrode (2), d'une part et une deuxième électrode (4) d'autre part, de façon à ce que, dans la cavité, un plasma soit généré, la deuxième électrode (4) étant disposée sur un côté d'un fond diélectrique (3) opposé à la cavité, qui est disposé en face de la cavité.

9. Procédé selon la revendication précédente, **caractérisé en ce qu'**une pluralité de cavités sont disposées sur la surface, les cavités étant conçues comme des passages dans une couche électro-conductrice.

10. Procédé selon l'une des revendications 8 à 9, **caractérisé en ce que** le procédé est un procédé pour le dépôt d'au moins une couche fonctionnelle au-dessus d'au moins un précurseur, la couche fonctionnelle étant hydrophile, hydrophobe, une couche d'amine, une couche d'époxyde, une couche d'acide carbonique ou une couche d'aldéhyde et au moins un précurseur contenant ou étant constitué d'alcoxysilane, de fluor gazeux, d'un hydrocarbure, d'un silane ou d'un organosilane.

11. Procédé selon l'une des revendications 8 à 10, **caractérisé en ce qu'**une surface d'un substrat diélectrique est revêtue, une épaisseur du substrat diélectrique étant ≥ 1 mm, de préférence ≥ 2 mm, plus particulièrement de préférence ≥ 10 mm.

12. Procédé selon l'une des revendications 8 à 11, un substrat diélectrique poreux étant traité et une profondeur de traitement dans le substrat étant pré-réglée, de préférence la profondeur étant réglée par la vitesse du gaz et/ou le débit de gaz.

13. Procédé selon l'une des revendications 8 à 12, **caractérisé en ce que** la surface d'un substrat diélectrique est traitée, de préférence **en ce que** la surface d'un textile, d'un tissu non-tissé ou d'une membrane est traitée.

14. Procédé selon l'une des revendications 8 à 13, **caractérisé en ce que** le gaz de la cavité est conduit à travers la surface à partir du côté de la surface à traiter opposé à la cavité.

15. Procédé selon l'une des revendications 8 à 14, **caractérisé en ce que** le plasma est observé de manière optique pendant le procédé.
